# EUROPEAN PATENT APPLICATION

(11) **EP 1 178 300 A1**
(43) Date of publication of application: **06.02.2002**
(21) Application number: 00116886.3
(22) Date of filing: 04.08.2000
(51) Int. Cl.: G01N 21/78, H01L 21/00

(54) **Arrangement and method for removing an organic material from a semiconductor device**

(71) Applicant: Infineon Technologies SC300 GmbH & Co. KG, 01099 Dresden (DE)
(72) Inventor: Marx, Eckhard, 01471 Radeburg (DE); Schneider, Torsten, 01458 Ottendorf-Okrilla (DE); Jakob, Anne, 01279 Dresden (DE); Stottko, Bernd, 01129 Dresden (DE)
(74) Representative: Fischer, Volker, Dipl.-Ing.

(57) **Abstract**

An arrangement and a method for removing an organic material from a semiconductor device are provided. The arrangement comprises a reactor (2) for enclosing at least one semiconductor device (20) with deposited organic material (22) and for enclosing a fluid (40) having ingredients (41, 42) for removing the organic material (22). An optical sensor system (3) is placed in a manner that emitted optical radiation (32) is transmitted through the fluid (40). The optical sensor system is connected to controlling means (4, 5, 6) which controls the insertion of at least one of the ingredients (42) due to the detected intensity (I) of the received optical radiation (34). The invention is suitable for optimization of the amount of at least one of the ingredients (42) used in the process.

## Description

The present invention relates to an arrangement and a method for removing an organic material from a semiconductor device, the arrangement comprising a reactor to receive at least one semiconductor device with deposited organic material and to receive a fluid having ingredients for removing the organic material from the semiconductor device.

In the technical field of manufacturing of semiconductor devices, the semiconductor devices often are formed like disks or wafers for producing e.g. semiconductor chips. In the process of manufacturing of e.g. a semiconductor wafer, it is common and necessary to apply various process steps to the wafer. Especially lithographic processes are applied frequently in the process. Before applying a lithographic process, the wafer usually is deposited with at least one material layer such as photoresist material. The photoresist material comprises organic material. By applying a lithographic process to the wafer which comprises at least one deposited layer of photoresist material, structures over the front side of the wafer can be performed. The structures can be performed by etching e.g. irradiated portions of the photoresist material. The structured photoresist layer then usually serves as a mask for further etching processes.

After a final etching process, it usually becomes necessary to remove the remaining portions of the photoresist layer before a next process or process step is applied. For removing organic material such as photoresist material from a semiconductor wafer it is common to use fluid acids with ingredients such as e.g. sulphuric acid and hydrogen peroxide. For this purpose, the fluid acid is enclosed in a reactor or a fluid bath container in which at least one semiconductor wafer with a deposited layer of photoresist material is to be inserted. When removing the organic material, carbon components of the photoresist material are oxidized and formed to carbon dioxide, the hydrogen components are formed to water. For this process, the fluid acid usually is heated e.g. up to 130 °C.

In such a process, the amount of used hydrogen peroxide generally depends on e.g. the type of photoresist material, the extent of the structuring and the amount of photoresist material to be removed. The latter especially depends on the number of wafers enclosed in the reactor. Thereby, especially two aspects have to be considered. It is necessary that the fluid acid contains a sufficient amount of hydrogen peroxide, so that a defined process time for removing the photoresist material can be performed and the photoresist material is converted sufficiently, so that the following processing of further wafers is not affected. On the other hand, it is desirable that the amount of hydrogen peroxide is not higher than necessary. If less hydrogen peroxide is used in the process, the amount of water which is formed during the process can be decreased. As a consequence, the lifetime of the process fluid increases. Therefore, the time intervals in which the fluid has to be renewed become larger.

In view of the prior art, it is an object of the present invention to provide an arrangement for removing an organic material such as photoresist material from a semiconductor device of the above-mentioned type, the arrangement being suitable for optimizing the amount of at least one of the ingredients of the fluid which is to be inserted into the reactor.

Further, it is an object of the present invention to provide a method for removing an organic material from a semiconductor device using a fluid having ingredients for removing the organic material, the method being suitable for optimizing the used amount of at least one of the ingredients of the fluid.

The object regarding the arrangement is solved by an arrangement of the above-mentioned type, the arrangement further comprising an optical sensor system for emitting optical radiation and for receiving of emitted optical radiation, controlling means for processing information about optical radiation intensity and for controlling an insertion of at least one of the ingredients into the reactor, the optical sensor system being placed in a manner that emitted optical radiation is transmittable through the fluid, the controlling means being connected to the optical sensor system.

The object regarding the method is solved by a method for removing an organic material from a semiconductor device comprising the steps of providing a reactor, inserting at least one semiconductor device with deposited organic material into the reactor, inserting fluid ingredients for removing the organic material from the semiconductor device into the reactor forming a fluid, emitting of optical radiation towards the fluid, receiving of optical radiation which is transmitted through the fluid, detecting of the received optical radiation intensity, and controlling of the insertion of at least one of the ingredients due to the detected optical radiation intensity.

The arrangement and method are applicable to various semiconductor devices with deposited organic material such as wafers for manufacturing of semiconductor chips. For example, the semiconductor device comprises a deposited layer of photoresist material. Further, various types of fluids can be used which are suitable for removing the organic material from the semiconductor device. Especially, a fluid is used having ingredients for removing photoresist material. Preferably, for removing photoresist material sulphuric acid and hydrogen peroxide are inserted as fluid ingredients.

With the provided arrangement and the provided method the amount of at least one of the ingredients such as hydrogen peroxide can be adapted. Furthermore, the process time for removing the organic material can be adapted to the amount of inserted organic material or the number of inserted wafers, respectively, and to different kinds of organic material or respective photoresist material.

With the optical sensor system the colour of the process fluid can be measured. To this end, the optical sensor system emits optical radiation and receives emitted optical radiation. Thereby, the optical radiation is emitted towards the fluid. By receiving of the optical radiation which is transmitted through the fluid the colour of the process fluid can be detected. With this information it can be assured that only semiconductor devices leave the process fluid which have been stripped off to a sufficient amount. If the process fluid is not clear enough this will be detected by the optical sensor system and e.g. a process alarm will occur. Especially, the process fluid is not clear if it contains portions of the removed organic material which are unoxidized. Also, it can be detected by the optical sensor system if the amount of water in the process fluid exceeds a defined value. For example, the content of water in the process fluid is related to a decrease of the sensor signal provided by the optical sensor system. As well, a decrease of the sensor signal is related to the amount of unoxidized portions in the stripped-off organic material.

Due to the sensor signal the insertion of at least one of the ingredients such as hydrogen peroxide is controlled. The controlling of the insertion can be performed in a manner that the consumption of the hydrogen peroxide in relation to the process time is optimized.

In a preferred embodiment, the arrangement comprises a radiation source for emitting optical radiation with a single wavelength. Preferably, blue light is emitted by the optical sensor system and transmitted through the fluid. Since the absorption of blue light by unoxidised portions in the stripped-off photoresist material is relatively high, a reliable detection of unoxidized organic material or respective photoresist material can be performed. For this purpose, the radiation source advantageously comprises a laser device or a light emitting diode.

According to another preferred embodiment, the optical sensor system is connected to the controlling means by means of an optical cable. By using an optical cable the controlling means do not need to be placed near to the optical sensor system, since the optical sensor system is placed in an aggressive environment performed by the fluid acid. Advantageously, the optical cable comprises a first optical fibre for transmitting the optical radiation which is to be emitted and a second optical fibre for transmitting received optical radiation. Therefore, both the sender for emitting the optical radiation and the receiver for receiving the transmitted optical radiation can be placed in a suitable environment.

According to another embodiment, the arrangement comprises a fluid pipe system for inserting the fluid into the reactor and for removing the fluid from the reactor. The optical sensor system is integrated into the fluid pipe system. Advantageously, the optical sensor system is integrated in a manner that no influence on the circulation process of the fluid (pressure and flow rate) is given.

In a further advantageous embodiment, the fluid pipe system comprises at least one filter for extracting particles and/or a degasifier for removing bubbles from the fluid. If heating of the fluid is necessary, the fluid pipe system further comprises a heater. Preferably, the heater and the optical sensor system are arranged to each other in a manner that a fluid stream through the fluid pipe system passes the heater and then the optical sensor system.

To improve the measuring functionality of the arrangement and the method the optical radiation is modulated for emitting and demodulated for receiving. Therefore, it is possible to perform a measuring that is independent from outside illumination. Further, if only maximum values of the received optical radiation intensity are detected within a defined time period an influence of bubbles induced by the process can be overcome by filtering of bubble-induced peaks of the sensor signal.

Further advantageous features, aspects and details of the invention are evident from the dependent claims.

The invention will be better understood by reference to the following description of embodiments of the invention, taking in conjunction with the accompanying drawings, wherein
- figure 1: shows an embodiment of the arrangement according to the invention;
- figure 2: shows a more detailed view of the optical sensor system;
- figure 3: shows a cross-sectional view of a wafer;
- figure 4: shows a diagram of a measured sensor signal in relationship to the process time.

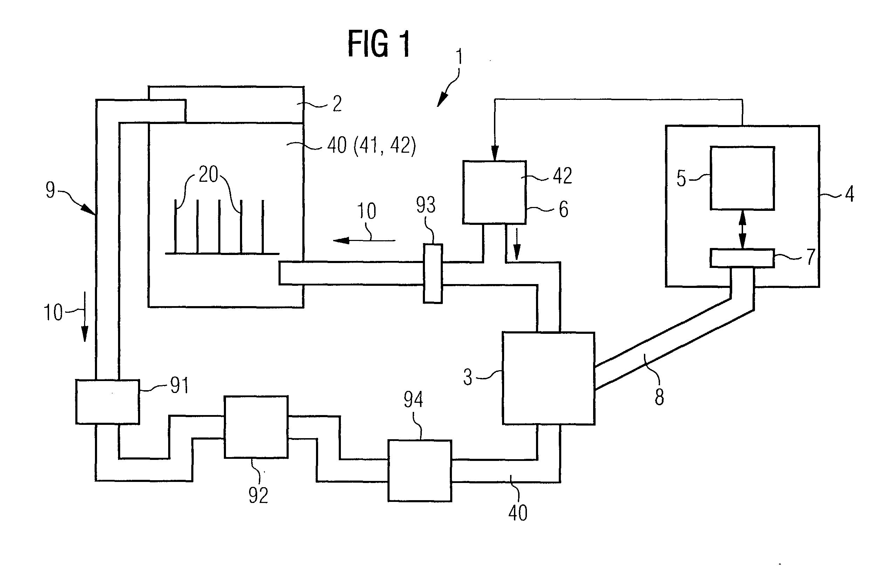

Figure 1 illustrates an embodiment of the arrangement according to the invention. The arrangement 1 comprises a reactor 2 for enclosing semiconductor devices 20 such as wafers. For example, the reactor 2 is suitable for enclosing a number of 5 up to 50 wafers piled up in a suitable clamping device. The reactor 2 can be on at least one side to form a tank or a bath. On the other hand it can be formed as a closed reactor with pipes connected to it. The wafers 20 have at least one deposited layer of photoresist material which is to be removed. In the reactor 2 also a fluid 40 having ingredients 41 and 42 for removing the photoresist material from the wafers 20 is enclosed. This type of process fluid also is known as so-called piranha.

Further, the arrangement 1 comprises a fluid pipe system 9 for inserting the fluid 40 into the reactor 2 and for removing the fluid 40 from the reactor 2. The fluid pipe system 9 comprises a pump 91 for performing a fluid stream 10 through the fluid pipe system 9. Further, the fluid pipe system 9 comprises a filter 92 for extracting particles out of the fluid 40 and a degasifier 93 for removing bubbles from the fluid 40, each of them placed at exemplified positions. The fluid pipe system 9 then comprises a heater 94 for heating the fluid 40 to e.g. 130 °C. An optical sensor system 3 is integrated into the fluid pipe system 9. The optical sensor system 3 and the heater 94 are arranged to each other in a manner that the fluid stream 10 through the fluid pipe system 9 first passes the heater 94 and then the optical sensor system 3.

The fluid 40 comprises sulphuric acid 41 (H2SO4) and hydrogen peroxide 42 (H2O2) as fluid ingredients. Additionally, ozone (O3) can be inserted as further ingredient of the fluid 40. With a spiking pump 6 the insertion of hydrogen peroxide 42 into the fluid pipe system 9 is controlled. The spiking pump 6 is connected to a controlling circuit 4 comprising a data processing unit 5. The spiking pump 6 is controlled by the controlling circuit 4. The data processing unit 5 and respective controlling circuit 4 are connected to the optical sensor system 3 by means of an optical cable 8. The controlling circuit 4 further comprises a radiation source 7 for emitting optical radiation which is transferred via the optical cable 8 to the optical sensor system 3. For example, the radiation source 7 comprises a laser device or a light emitting diode for emitting optical radiation with a single wavelength.

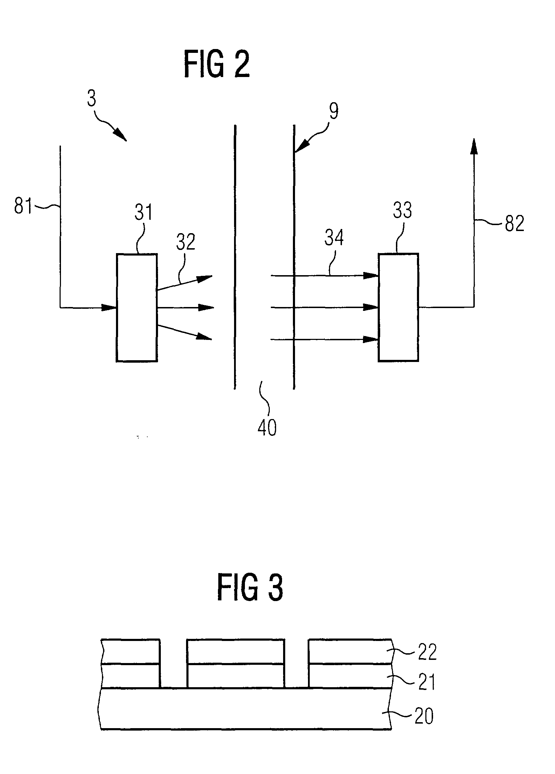

Figure 2 shows a more detailed view of the optical sensor system 3. The pipe of the fluid pipe system 9 containing the fluid 40 is arranged in the centre of the optical sensor system 3. The optical sensor system 3 comprises a sender 31 for emitting optical radiation 32 towards the fluid 40. The optical radiation 32 is provided by an optical fibre 81 which is part of the optical cable 8 according to figure 1. The radiation 32 which is to be emitted is transmitted from the radiation source 7 via the optical fibre 81. The optical sensor system 3 further comprises a receiver 33 for receiving of emitted optical radiation. Especially, the receiver 33 is designed for receiving of the optical radiation 34 which is transmitted through the fluid 40. The received optical radiation 34 is transmitted to the controlling circuit 4 via the optical fibre 82 as part of the optical cable 8.

Figure 3 schematically shows a cross-sectional view of one of the wafers 20 enclosed in the reactor 2 according to figure 1. The wafer 20 is deposited with layers 21 and 22. Layer 22 is formed of photoresist material irradiated in a lithographic process. The photoresist layer 22 forms a mask for etching the layer 21. After the etching process, trenches are formed as shown in figure 3. In a following process, the remaining portions of the photoresist layer 22 have to be removed by inserting the wafer 20 into the reactor 2 according to figure 1.

With the optical sensor system 3 the transmission of blue light (wavelength of about 550 nm) through the fluid 40 is measured. By removing the photoresist material 22 from the wafer 20 the fluid 40 changes its colour. When the removed photoresist material is fully oxidized, the fluid 40 is nearly as clear as at the beginning of the process. The described change of colour can be measured by the optical sensor system 3. To be independent from outside illumination, the optical radiation is modulated for emitting and demodulated for receiving. This can be performed by the data processing unit 5. If, within a defined time period, only maximum values of the received optical radiation intensity are detected, the result of the measurement is not influenced by induced bubbles which usually lead to scattering of the transmitted radiation.

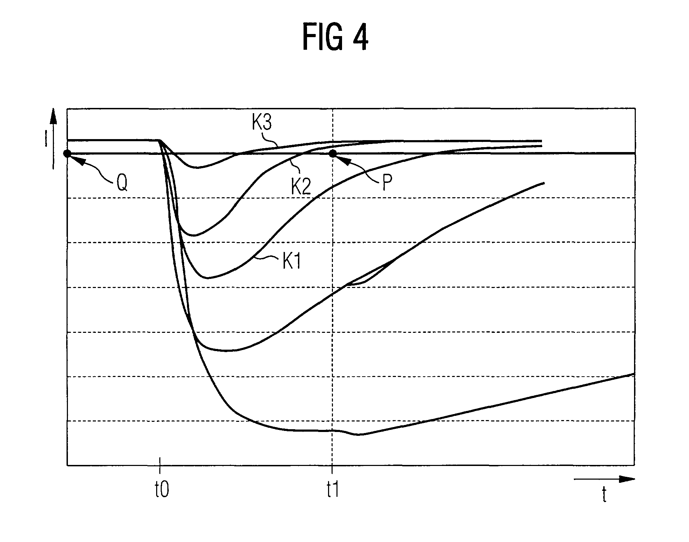

Figure 4 shows a diagram of a measured sensor signal I in relationship to the process time t. The sensor signal I is derived from the detected optical radiation intensity measured by the optical sensor system 3. In this example, the optical radiation intensity is detected and transferred into a voltage signal. Figure 4 shows the sensor signal I derived from the received radiation intensity. The diagram schematically shows an example of a process for removing photoresist materials deposited on five wafers 20. There are shown three curves K1 to K3, each for a different number of strokes of the spiking pump 6 pumping the hydrogen peroxide 42 into the fluid pipe system 9. The curve K1 designates the lowest number of strokes. The curve K3 designates the highest number of strokes.

The process begins with the time t0. The large decrease of each of the curves at the beginning of the process denotes the extent of the dissolution of the photoresist material. Since a relative high amount of unoxidized portions in the stripped-off photoresist material occurs at the beginning of the process, the absorption of the transmitted light through the fluid 40 is quite large. Therefore, the signal I decreases. With the inserting of hydrogen peroxide 42 into the fluid 40 the process of oxidation of the photoresist material can be accelerated. This is illustrated by the different increases of the curves K1 to K3. When the curves exceed the level Q which is a value for a minimum process fluid quality (for example 90 % of the initial value of the signal I), the fluid 40 is clear enough for inserting the next lot of wafers. The time t1 denotes the end of the process. For the curves K2 and K3, a sufficient process fluid quality for a next process is reached. The optimized number of strokes of the spiking pump 6 will be probably between the number of strokes of the curves K1 and K2 to meet exactly the point P.

For instance, an end point detection is performed. To this end, the sensor signal I is compared with the initial signal I of the clean process fluid before the wafers 20 are inserted into the reactor 2. The difference between these two signals has to be in a defined range after a certain time limit. The optical sensor system 3 can detect one wafer with deposited photoresist material entering the reactor 2. The optical sensor system 3 can detect two different states, e.g. "process fluid clean" or "process fluid not clean". If the process time is finished and the process fluid or respective fluid is not clean, an additional amount of hydrogen peroxide and process time will be added.

In a further embodiment, a process control can be performed with the goal of reduction of the hydrogen peroxide consumption and process time. The intensity of the received optical radiation is detected and the generated sensor signal, e.g. the slope of descent of the signal which is a function of the number of coated wafers inserted into the process fluid, is compared with a pre-defined table with signals on defined time stamps, the signals being characteristic for a process fluid which is not full with wafers. The sensor signal is compared with the predefined table during the process at certain time steps. Due to the results of the comparison, the amount of hydrogen peroxide to be inserted into the fluid is controlled. This can be performed with a special control algorithm, e.g. with a PID-controller with a pre-defined target value. In a second method, the point of strongest absorption can be measured (characterized by a minimum value of the respective curve).

For process cost minimization, the optical radiation intensity or respective sensor signal is monitored over a defined time period. The lifetime of the process fluid can be monitored by monitoring the sensor signal since the content of water in the fluid which is formed during several processes is related to the course of recovery of the process fluid after removing the photoresist material of a lot of wafers. With the ageing of the fluid the recovery time of the process fluid becomes larger. The tracking of the recovery time can be used to define the lifetime of the process fluid. As an alternative, a maximum amount of hydrogen peroxide per each of the wafers or the batches and a maximum process time period are defined. If a lot of wafers or a batch can't be processed completely in the defined time period with the defined amount of hydrogen peroxide (level Q isn't exceeded), a change of the fluid has to be made.

## Claims

1. Arrangement for removing an organic material from a semiconductor device comprising
- a reactor (2) to receive at least one semiconductor device (20) with deposited organic material (22) and to receive a fluid (40) having ingredients (41, 42) for removing the organic material (22) from the semiconductor device (20),
- an optical sensor system (3) for emitting optical radiation (32) and for receiving of emitted optical radiation (32),
- controlling means (4, 5, 6) for processing information about optical radiation intensity (I) and for controlling an insertion of at least one of the ingredients (42) into the fluid (40),
- the optical sensor system (3) being placed in a manner that emitted optical radiation (32) is transmittable through the fluid (40),
- the controlling means (4, 5, 6) being connected to the optical sensor system.

2. The arrangement according to claim 1,
**characterized in that**
the arrangement (1) comprises a radiation source (7) for emitting optical radiation (32) with a single wavelength.

3. The arrangement according to claim 2,
**characterized in that**
the radiation source (7) comprises a laser device or a light emitting diode.

4. The arrangement according to anyone of claims 1 to 3,
**characterized in that**
the optical sensor system (3) is connected to the controlling means (4, 5, 6) by means of an optical cable (8).

5. The arrangement according to claim 4,
**characterized in that**
the optical cable (8) comprises a first optical fibre (81) for transmitting the optical radiation (32) which is to be emitted and a second optical fibre (82) for transmitting received optical radiation (34).

6. The arrangement according to anyone of claims 1 to 5,
**characterized in that**
- the arrangement (1) comprises a fluid pipe system (9) for inserting the fluid (40) into the reactor (2) and for removing the fluid (40) from the reactor (2),
- the optical sensor system (3) is integrated into the fluid pipe system (9).

7. The arrangement according to claim 6,
**characterized in that**
the fluid pipe system (9) comprises at least one filter (92) for extracting particles and/or a degasifier (93) for removing bubbles from the fluid (40).

8. The arrangement according to claim 6 or 7,
**characterized in that**
the fluid pipe system (9) comprises a heater (94) for heating the fluid (40).

9. The arrangement according to claim 8,
**characterized in that**
the heater (94) and the optical sensor system (3) are arranged to each other in a manner that a fluid stream (10) through the fluid pipe system (9) passes the heater (94) and then the optical sensor system (3).

10. Method for removing an organic material from a semiconductor device comprising the steps of
- providing a reactor (2),
- inserting at least one semiconductor device (20) with deposited organic material (22) into the reactor (2),
- inserting fluid ingredients (41, 42) for removing the organic material (22) from the semiconductor device (20) into the a fluid (40),
- emitting of optical radiation (32) towards the fluid (40),
- receiving of optical radiation (34) which is transmitted through the fluid (40),
- detecting of the received optical radiation intensity (I),
- controlling of the insertion of at least one of the ingredients (42) due to the detected optical radiation intensity (I) .

11. The method according to claim 10,
**characterized in that**
the optical radiation (32, 34) is modulated for emitting and demodulated for receiving.

12. The method according to anyone of claims 10 or 11,
**characterized in that**
within a defined time period only maximum values of the received optical radiation intensity (I) are detected.

13. The method according to anyone of claims 10 to 12,
**characterized in that**
sulphuric acid (41) and hydrogen peroxide (42) are inserted as fluid ingredients.

14. The method according to claim 13,
**characterized in that**
the insertion of hydrogen peroxide (42) is controlled.

15. The method according to anyone of claims 10 to 14,
**characterized in that**
the optical radiation intensity (I) is monitored over a defined time period.

16. The method according to anyone of claims 10 to 15,
**characterized in that**
- at least one semiconductor device (20) having at least one layer of photoresist material (22) is inserted into the reactor (2),
- fluid ingredients (41, 42) for removing the photoresist material (22) from the semiconductor device (20) are inserted into the reactor (2).
